# EUROPÄISCHE PATENTANMELDUNG

(11) **EP 1 469 496 A1**
(43) Veröffentlichungstag der Anmeldung: **20.10.2004**
(21) Anmeldenummer: 03010338.6
(22) Anmeldetag: 08.05.2003
(51) Int. Cl.: H01H 21/22

(54) **Funkpiezotaster**

(30) Priorität: 16.04.2003 DE 10317481
(71) Anmelder: PAUL HOCHKÖPPER GmbH & Co. KG, D-58511 Lüdenscheid (DE)
(72) Erfinder: Hajdukovic, Dragan, T., 58513 Lüdenscheid (DE); Heine, Harald, 58507 Lüdenscheid (DE)
(74) Vertreter: Dörner, Lothar, Dipl.-Ing.

(57) **Zusammenfassung**

Ein Funkpiezotaster mit einer Grundplatte, die einen Funkpiezomodul aufnimmt. Das technische Problem ist eine sichere und funktionsgerechte Montage des Funkpiezomoduls. Der Funkpiezomodul (12) nimmt Tastwippen (15) in Wälzlagern auf, ein Steg (22) ist auf den Funkpiezomodul aufklemmbar und führt so die Tastwippen (15) in den Wälzlagern, und der Steg (22) ist mit Rastnasen (29) in Nasen (6) der Grundplatte (1) verrastbar. Fig. 1.

## Beschreibung

Die Erfindung betrifft einen Funkpiezotaster mit einer Grundplatte, die einen Funkpiezomodul aufnimmt.

Bei Funkpiezotastern ergeben sich insbesondere hinsichtlich der Auswahl der verschiedenen Funkkanäle und auch der Schaltwege besondere Probleme in Verbindung mit der Montagetechnik herkömmlicher Installationsgeräte. Einerseits soll der Funkpiezotasten in einen Mehrfachabdeckrahmen einer Unterputzinstallation einbaubar sein, andererseits soll der Funkpiezotaster als Einzelgerät unabhängig von der Elektroinstallation anbringbar sein.

Aufgabe der Erfindung ist eine sichere und funktionsgerechte Montage des Funkpiezomoduls.

Diese Aufgabe wird nach einem ersten Ausführungsbeispiel der Erfindung dadurch gelöst, daß der Funkpiezomodul Tastwippen in Wälzlagern aufnimmt, daß ein Steg auf den Funkpiezomodul aufklemmbar ist und so die Tastwippen in den Wälzlagern führt und daß der Steg mit Rastnasen in Nasen der Grundplatte verrastbar ist.

Die Erfindung unterscheidet sich insofern vom Stand der Technik, als ein Steg die Schaltfunktrion führt und außerdem eine Montage der gesamten Anordnung ermöglicht. Die Anordnung ist ein Installationssystem integrierbar.

Aufgabe ist auch eine Montage des Funkpiezotasters an beliebiger Stelle.

Diese Aufgabe wird nach einem zweiten Ausführungsbeispiel der Erfindung dadurch gelöst, daß der Funkpiezomodul auf der Grundplatte verrastbar ist und daß eine zweischenklige Schaltwippe mit Schlitzen über Zapfen des Funkpiezomoduls greift.

Dieses Ausführungsbeispiel der Erfindung unterscheidet sich vom Stand der Technik dadurch, daß der Funkpiezomodul auf der Grundplatte festgehalten ist und die Schaltwippe auf dem Funkpiezomodul sitzt.

Zur sicheren Ansteuerung des jeweiligem Funkkanals ist vorgesehen, daß die Betätigungsnocken zur Auswahl des jeweiligen Funkkanals vor der Schaltung des Piezosenders durch die Leiste mit dem zugeordneten Taststift bzw. den zugeordneten Taststiften in Eingriff kommen.

Ein Schutz des Funkpiezotasters wird dadurch erreicht, daß ein Abdeckrahmen auf der Grundplatte verrastbar ist.

Eine Vormontage der Anordnung ist dadurch möglich, daß der Steg auf Zapfen des Funkpiezomoduls aufklemmbar ist und als Montageträger für die Anordnung dient.

Eine leichte Betätigung der Leisten zum Schalten wird dadurch erreicht, daß an den Tastwippen und den Schaltwippen Betätigungsprofile für die Leiste vorgesehen sind.

Ausführungsbeispiele werden anhand der Zeichnungen erläutert, in denen darstellen:
Fig. 1 eine Explosionsdarstellung eines ersten Ausführungsbeispiels,
Fig. 2 eine Darstellung einer Grundplatte und eines Abdeckrahmens vor der Montage,
Fig. 3 Grundplatte und Abdeckrahmen in montiertem Zustand,
Fig. 4 eine Einzelheit aus Fig. 3,
Fig. 5 einen Funkpiezomodul mit Steg vor der Montage,
Fig. 6 eine Einzelheit aus Fig. 5,
Fig. 7 eine Unteransicht zu Fig. 5,
Fig. 8 eine Einelheit aus Fig. 7,
Fig. 9 Steg und Funkpiezomodul in montiertem Zustand.
Fig. 10 den Funkpiezomodul mit einer Tastwippe vor der Montage,
Fig. 11 den Funkpiezomodul mit der Tastwippe in montiertem Zustand,
Fig. 12 eine Draufsicht auf den Funkpiezomodul mit Tastwippe,
Fig. 13 einen Schnitt nach der Linie A-A in Fig. 12,
Fig. 14 eine Einzelheit aus Fig. 13,
Fig. 15 den Steg und den Abdeckrahmen vor der Montage,
Fig. 16 den Steg und den Abdeckrahmen in montiertem Zustand,
Fig. 17 eine Einzelheit aus Fig. 16,

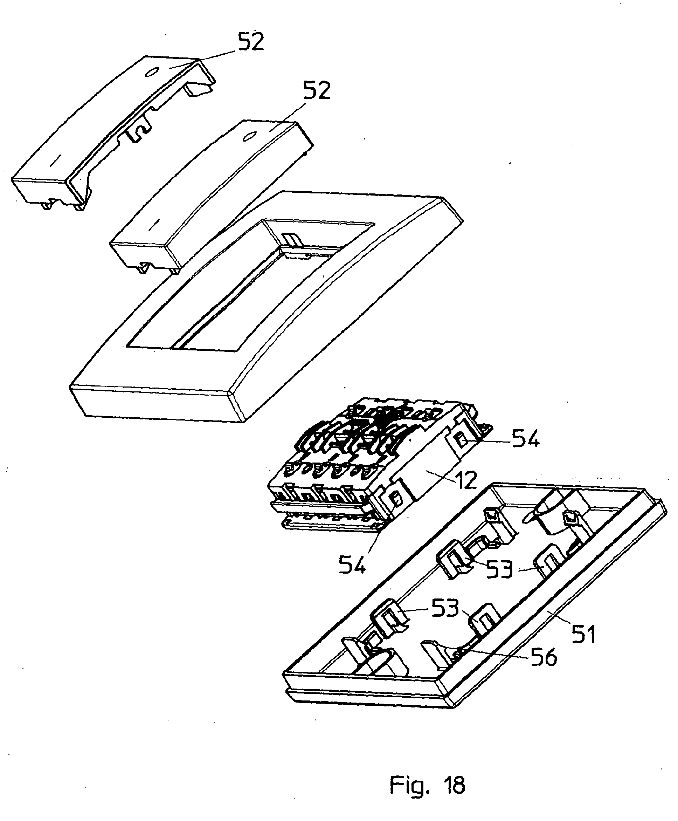

Fig. 18 eine Explosionsdarstellung eines zweiten Ausführungsbeispiels,

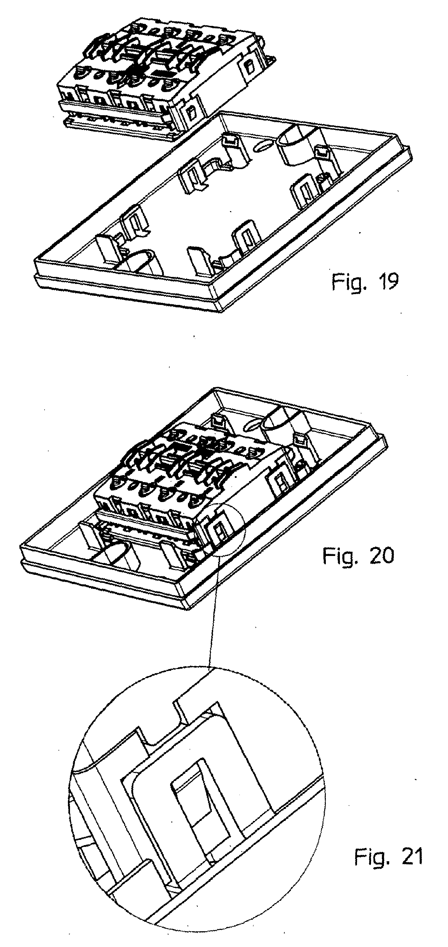

Fig. 19 eine Darstellung einer Grundplatte und eines Funkpiezomoduls vor der Montage,
Fig. 20 Grundplatte und Funkpiezomodul in montiertem Zustand,

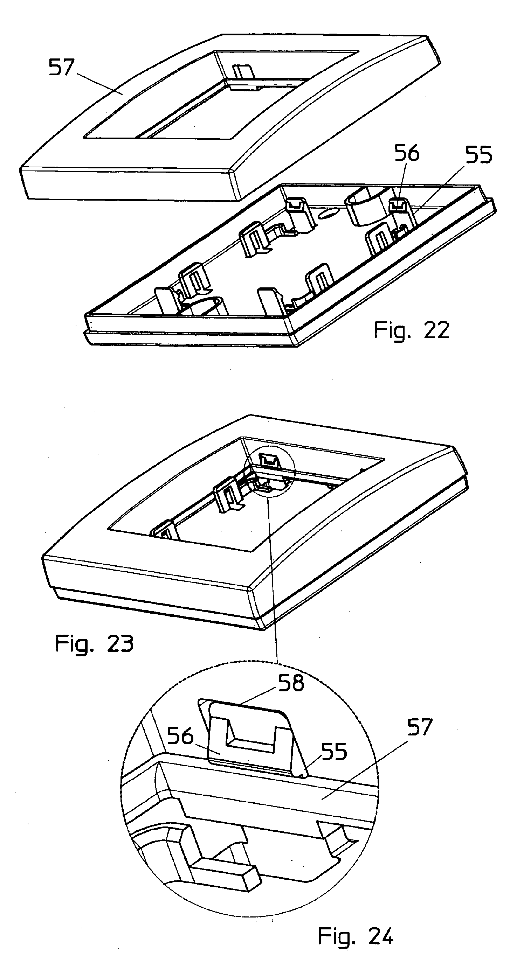

Fig. 21 eine Einzelheit aus Fig. 20,
Fig. 22 Grundplatte und Abdeckrahmen vor der Montage,
Fig. 23 Grundplatte und Abdeckrahmen in montiertem Zustand,
Fig. 24 eine Einelheit aus Fig. 23,

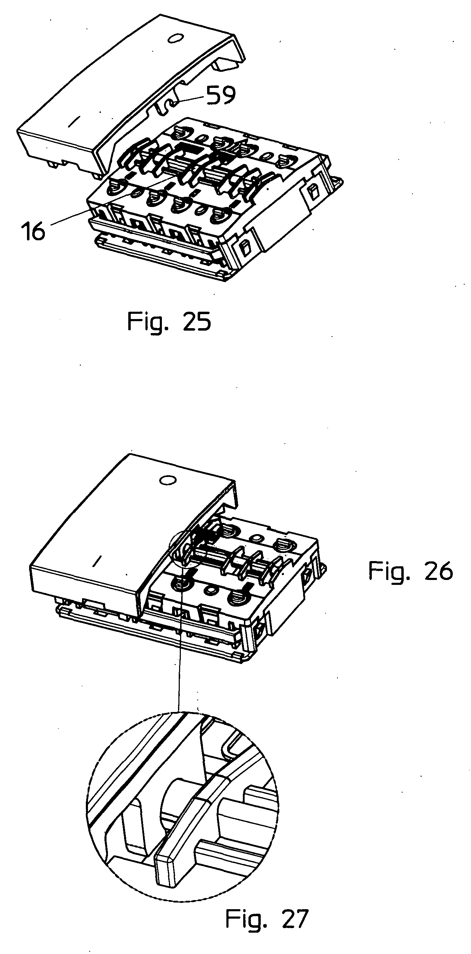

Fig. 25 den Funkpiezomodul mit einer Wippe vor der Montage,
Fig. 26 den Funkpiezomodul mit Wippe in montiertem Zustand,
Fig. 27 eine Einzelheit aus Fig. 26,

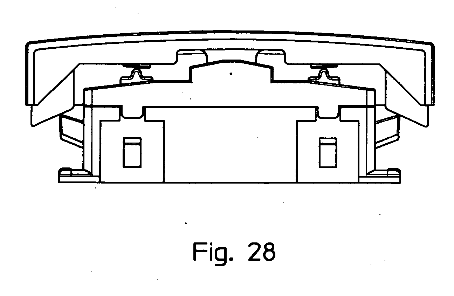

Fig. 28 eine Seitenansicht des Funkpiezotasters.

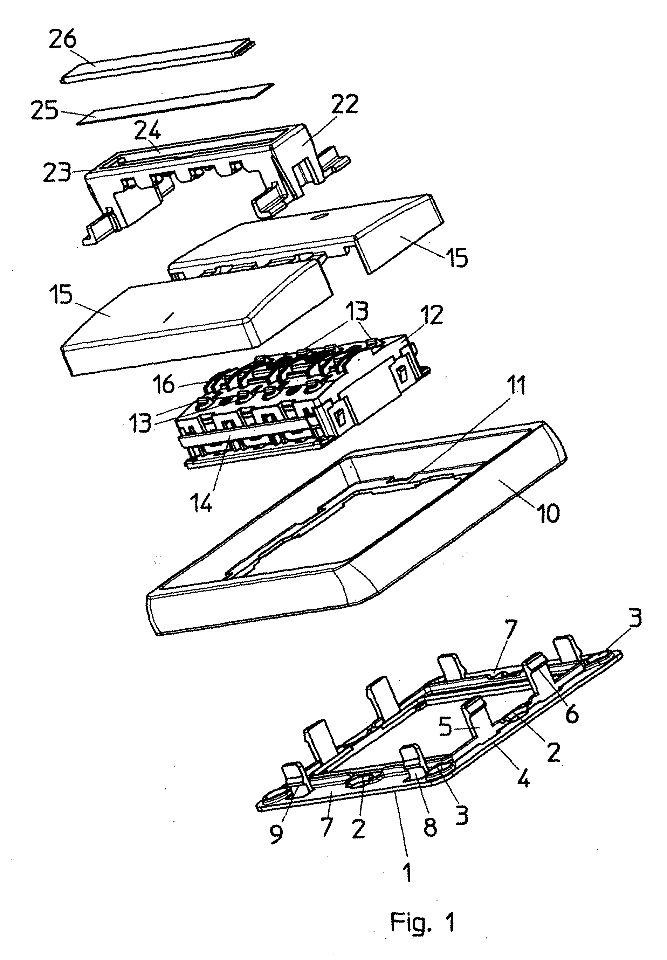

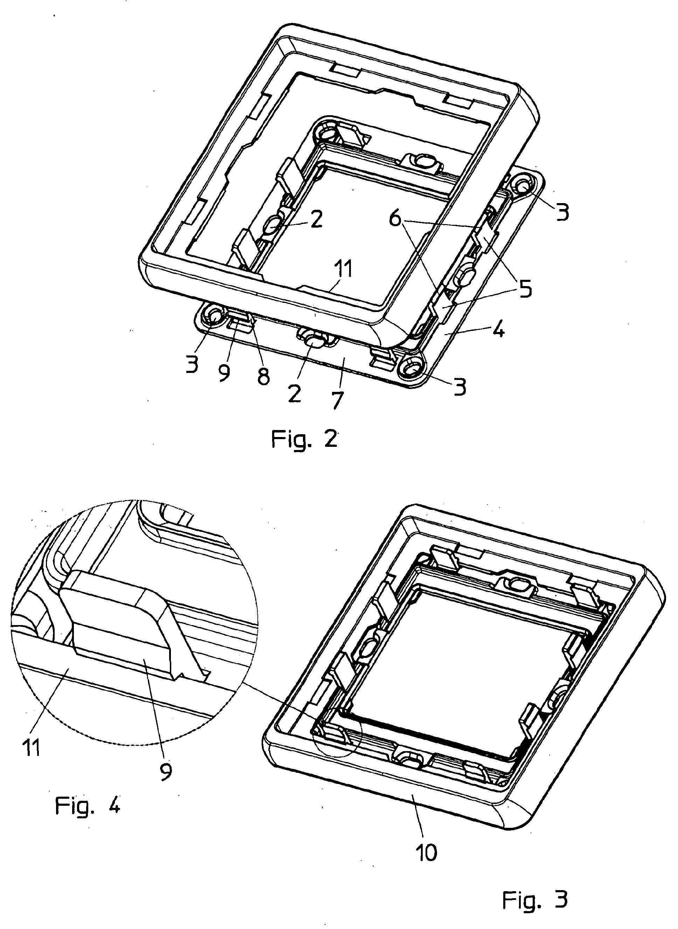

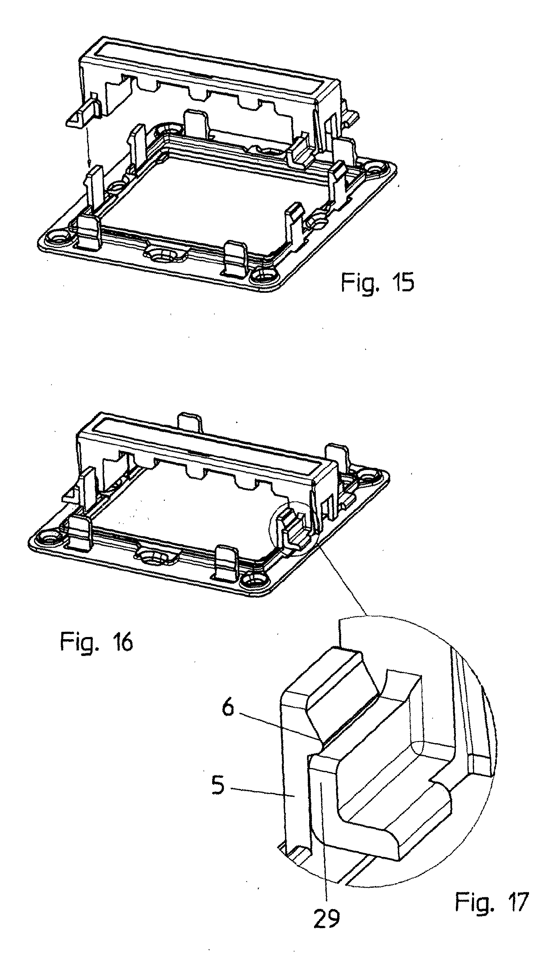

Das erste Ausführungsbeispiel nach den Fig. 1 bis 17 arbeitet mit Tastwippen und ist auf einer qudratischen Grundplatte 1 aufgebaut, deren Durchgänge 2 eine Befestigung auf einer nicht dargestellten Umterputzdose und deren Durchgänge 3 eine Befestigung auf einer ebenen Unterlage wie einer Wand erlauben. An zwei einander gegenüberliegenden Leisten 4 der Grundplatte 1 befinden sich nach oben gerichtete Zungen 5 mit nachgiebigen und rastenden Nasen 6. An den beiden anderen Leisten 7 der Grundplatte 1 befinden sich ebenfalls nach oben gerichtete Zungen 8 mit nachgiebigen und rastenden Nasen 9. Damit ist eine Rastung der Nasen 6 und 9 mit einem Gegenelement möglich.

Ein Abdeckrahmen 10 mit einem nach innen vorspringenden Innensteg 11 ist auf die Grundplatte 1 aufsetzbar, wobei der Innensteg 11 mit den Nasen 9 verrastet. Dadurch ist der Abdeckrahmen 10 auf der Grundplatte 1 festgelegt.

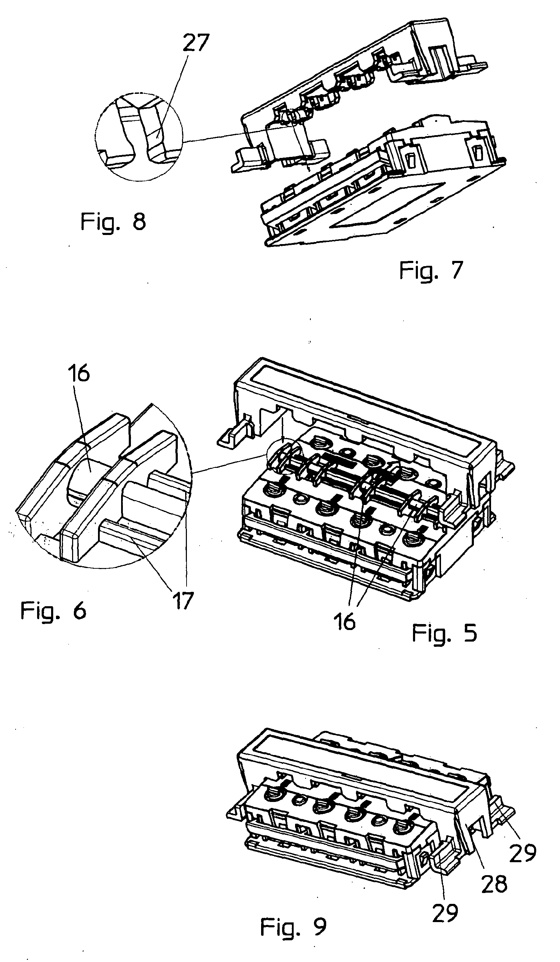

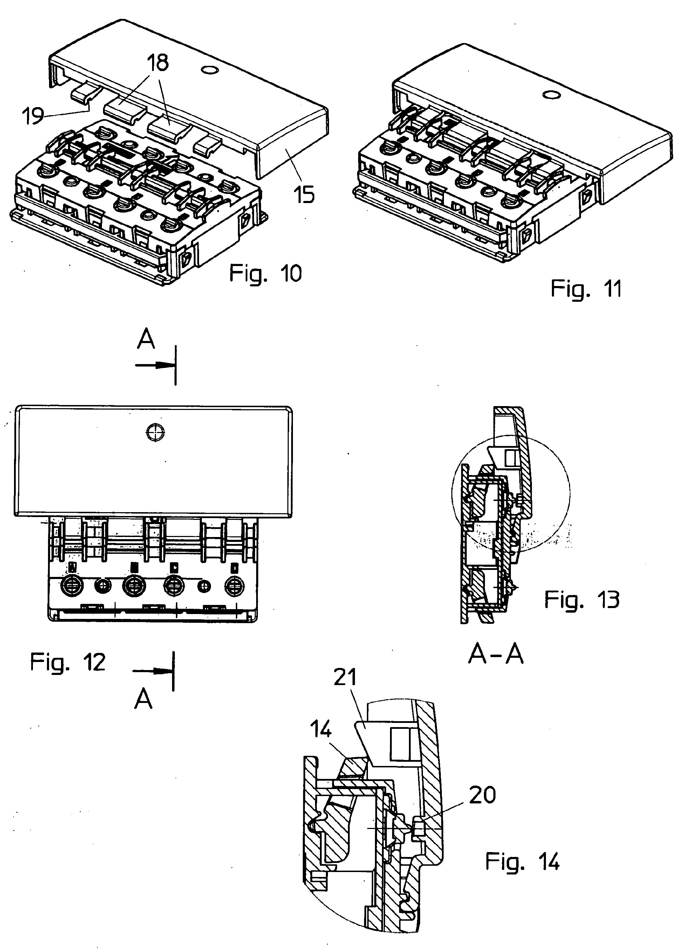

Ein batterieloser Funkpiezomodul 12 beistzt eine Mehrzahl von Taststiften 13 zur Anwahl eines jeweiligen Kanals. Eine schwenkbare, vorgespannte Leiste 14 dient zur Schaltung des Funkpiezomoduls durch je eine Tastwippe 15, wie noch näher erläutert wird. Auf der Kopfseite des Funkpiezomoduls 12 ist ein abschnittweise ausgebildeter Zapfen 16 vorgesehen, vgl. insbesondere Fig. 5 und 10. Zwischen den Abschnitten des Zapfens 16 sind beidseitig versetzt zu der Achse des Zapfens 16 Wälzzapfen 17 für je eine Tastwippe 15 vorgesehen.

Jede Tastwippe 15 weist Zungen 18 auf, die mit zylindrischen Wälzschalen 19 über die Wälzzapfen 17 greifen, so daß die Tastwippen 15 um die Wälzzapfen 17 schwenkbar sind. Auf der Unterseite der Tastwippen 15 befinden sich ein oder mehrere Betätigungsnocken 20 für entsprechende Taststifte 13 des Funkpiezomoduls 12, die dem gewünschten Kanal zugeordnet sind. Die Anordnung der Betätigungsnokken 20 hängt von dem jeweils zu schaltenden Kanal des Funkpiezomoduls 12 ab. Außerdem sind Betätigungsprofile 21 für die Leiste 14 vorgesehen.

Ein Steg 22 dient zum Zusammenhalt des gesamten Funkpiezotasters, vgl. insbesondere Fig. 1 und 6 bis 9. Auf der Kopfleiste 23 des Steges 22 ist in einem Ausschnitt 24 ein Beschriftungsträger 25 aufgenommen, der durch eine Scheibe 26 abgedeckt ist. Unterhalb der Kopfleiste 23 befinden sich mehrere Schlitze 27 mit hinterschnittenen Rändern, die klemmend über die Zapfen 16 greifen. Dadurch wird einerseits der Steg 22 auf dem Funkpiezomodul 12 festgehalten, andererseits werden die Zungen 18 der Tastwippen 15 mit den Wälzzapfen 17 in Eingriff gehalten. An Schenkeln 28 des Steges 22 sind Rastnasen 29 angeformt, die hinter die Nasen 6 der Grundplatte 1 rastend eingreifen.

Die Montage des Funkpiezotasters ergibt sich weitgehend aus der vorstehenden Beschreibung. Zusammenfassend ist folgendes nachzutragen: Die Tastwippen 15 werden mit den Wälzschalen 19 auf die Wälzzapfen 17 gelegt. Dann wird der Steg 22 auf die Zapfen 16 des Funkpiezomoduls 12 aufgedrückt, so daß diese Funktionsteile zuammengehalten sind und die Tastwippen 15 in den Wälzlagern geführt.

Nachdem die Grundplatte 1 z.B. mittels der Durchgänge 2 auf einer Unterputzdose befestigt ist und der Abdeckrahmen 10 auf die Grundplatte 1 aufgeklemmt ist, wird der Steg 22 mit dem Funkpiezomodul 12 und den Tastwippen 15 in die Öffnung des Abdeckrahmen 10 eingeführt und an den Nasen 6 verrastet. Damit ist der Funkpiezotaster funktionsfertig. Dieses erste Ausführungsbeispiel kann in der beschriebenen Weise auf einer Unterpuzdose montiert und in eine Elektroinstallation, insbesondere in einen Mehrfachabdeckrahmen integriert werden. Es ist auch mithilfe der Durchgänge 3 eine Aufputzmontage möglich. Man kann anstelle von einer Tastwippe auch mehrere Tastwippen nebeneinander anordnen, um so mehrere Funkkanäle unabhängig voneinander zu schalten.

Das zweite Ausführungsbeispiel nach den Fog. 18 bis 28 unterscheidet sich von dem ersten Ausführungsbeispiel dadurch, daß der Aufbau auf einer Grundplatte 51 erfolgt, die auf einer ebenen Unterlage wie einer Wand festegelegt wird, und zur Betätigung des Funkpiezomoduls 12 sind zweischenklige Schaltwippen 52 vorgesehen. Die Grundplatte 51 weist augenförmige Zungen 53 auf, in die Nasen 54 des Funkpiezomoduls 12 einrasten .Der Funkpiezomodul 12 wird also unmittelbar in der Grundplatte 51 verankert.

Außerdem hat die Grundplatte weitere Zungen 55 mit Rastnasen 56. Über die Grundplatte 51 greift ein Rahmen 57, in dessen Fenster 58 die Rastnasen 56 einrasten und den Rahmen 57 festhalten.

Die Schaltwippen 52 greifen mit hinterschnittenen Schlitzen 59 über die Zapfen 16. Die Wippen 52 sind also auf den Zapfen schwenkbar und betätigen entsprechend der Verschwenkung den zugeordneten Kanal des Funkpiezomoduls.

## Patentansprüche

1. Funkpiezotaster mit einer Grundplatte, die einen Funkpiezomodul aufnimmt, **dadurch gekennzeichnet, daß** der Funkpiezomodul (12) Tastwippen (15) in Wälzlagern aufnimmt, daß ein Steg (22) auf den Funkpiezomodul aufklemmbar ist und so die Tastwippen (15) in den Wälzlagern führt und daß der Steg (22) mit Rastnasen (29) in Nasen (6) der Grundplatte (1) verrastbar ist.

2. Funkpiezotaster mit einer Grundplatte, die einen Funkpiezomodul aufnimmt, **dadurch gekennzeichnet, daß** der Funkpiezomodul auf der Grundplatte (51) verrastbar ist und daß eine zweischenklige Schaltwippe (52) mit Schlitzen (57) über Zapfen (16) des Funkpiezomoduls greift.

3. Funkpiezotaster nach Anspruch 1 oder 2, **dadurch gekennzeichnet, daß** die Betätigungsnocken (2) zur Auswahl des jeweiligen Funkkanals vor der Schaltung des Piezosenders durch die Leiste (14) mit dem zugeordneten Taststift (13)bzw. den zugeordnten Taststiften in Eingriff kommen.

4. Funkpiezotaster nach einem der Ansprüche 1 bis 3, **dadurch gekennzeichnet, daß** ein Abdeckrahmen (10) auf der Grundplatte (1) verrastbar ist.

5. Funkpiezotaster nach einem der Ansprüche 1 bis 4, **dadurch gekennzeichnet, daß** der Steg (22) auf Zapfen (16) des Funkpiezomoduls (12) aufklemmbar ist und als Montageträger für die Anordnung dient.

6. Funkpiezotaster nach einem der Ansprüche 1 bis 5, **dadurch gekennzeichnet, daß** an den Tastwippen (15) und den Schaltwippen (52) Betätigungsprofile (21) für die Leiste (14) vorgesehen sind.
